(19) Europäisches Patentamt
European Patent Office
Office européen des brevets

(11) **EP 1 691 518 B1**

(12) **EUROPÄISCHE PATENTSCHRIFT**

(45) Veröffentlichungstag und Bekanntmachung des Hinweises auf die Patenterteilung:
**29.04.2015 Patentblatt 2015/18**

(51) Int Cl.:
*H04L 27/36* *(2006.01)*

(21) Anmeldenummer: **06000297.9**

(22) Anmeldetag: **09.01.2006**

(54) **Sende-/Empfangseinrichtung mit einem eine einstellbare Vorverzerrung aufweisenden Polar-Modulator**

Transceiver device comprising a polar modulator with adjustable predistortion

Dispositif émeteur-récepteur comprennant un modulateur polaire avec prédistortion réglable

(84) Benannte Vertragsstaaten:
**DE FR GB**

(30) Priorität: **10.02.2005 DE 102005006162**

(43) Veröffentlichungstag der Anmeldung:
**16.08.2006 Patentblatt 2006/33**

(73) Patentinhaber: **Intel Mobile Communications GmbH**
**85579 Neubiberg (DE)**

(72) Erfinder: **Li Puma, Giuseppe**
**44791 Bochum (DE)**

(74) Vertreter: **Patentanwälte Lambsdorff & Lange**
**Dingolfinger Strasse 6**
**81673 München (DE)**

(56) Entgegenhaltungen:
**US-A1- 2003 035 499    US-A1- 2004 151 257**

**Beschreibung**

Die Erfindung betrifft eine Sende-/Empfangseinrichtung für ein Mobilfunkgerät, welche einen Polar-Modulator umfasst, wobei der Polar-Modulator eine einstellbare Vorverzerrung aufweist. Außerdem betrifft die Erfindung ein Verfahren zur Einstellung der Vorverzerrung in einem derartigen Polar-Modulator.

In dem Sender eines Mobilfunkgeräts dient der Modulator zur Transformation eines binären Datenstroms in ein moduliertes Trägersignal. Dazu wird der binäre Datenstrom in Abhängigkeit der Modulationsart zunächst in komplexwertige digitale Datensymbole umgewandelt. Anschließend werden die Datensymbole zur Erhöhung der spektralen Effizienz einer sendeseitigen Pulsformung unterzogen. Das resultierende Basisbandsignal wird dann auf einen Träger gemischt.

Der Modulator kann dabei als I/Q-Modulator oder als Polar-Modulator realisiert sein.

Bei einem I/Q-Modulator wird das komplexe Basisbandsignal in kartesischer Darstellung nach Real- und Imaginäranteil getrennt mit zwei orthogonalen Trägersignalen gemischt. Der Real- und der Imaginäranteil werden auch als I-Anteil (in phase) bzw. Q-Anteil (quadratur phase) bezeichnet. Anschließend werden die beiden resultierenden Hochfrequenzsignale addiert und verstärkt. Nachteilig an einem I/Q-Modulator ist im Vergleich zum nachfolgend beschriebenen Polar-Modulator der erhöhte Leistungsverbrauch und der höhere Bedarf an Chipfläche.

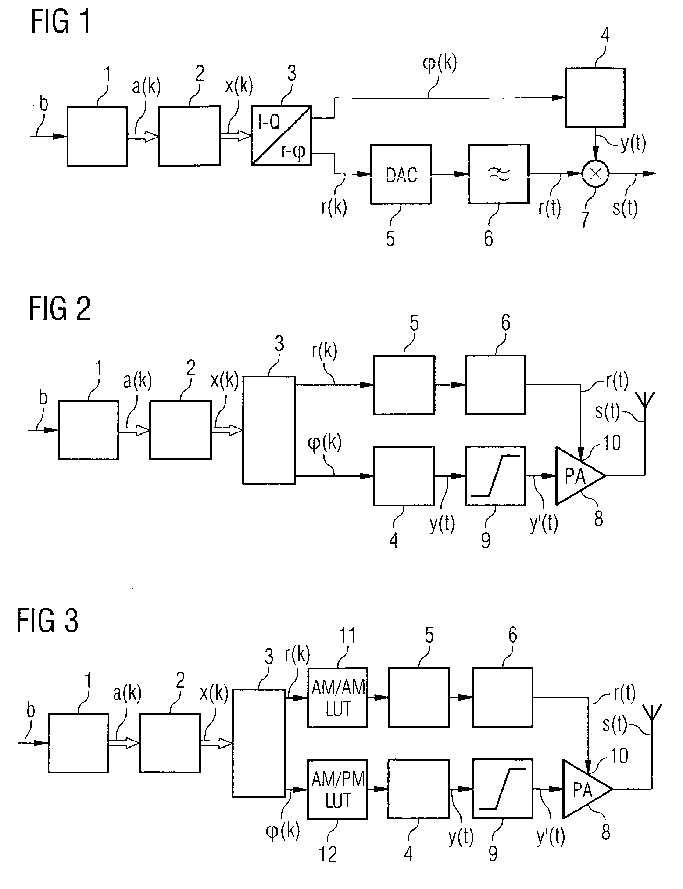

Bei einem Polar-Modulator wird das komplexe Basisbandsignal in Polardarstellung getrennt nach Betrag und Phase verarbeitet. In Fig. 1 ist das Prinzipschaltbild eines Polar-Modulators dargestellt. Ein binärer Datenstrom b wird zunächst mittels eines Symbol-Mappers 1 in eine komplexwertige Symbolfolge a(k) gewandelt. Die komplexwertige Symbolfolge a(k) umfasst dabei einen I- und einen Q-Anteil. Die komplexwertige Symbolfolge a(k) wird anschließend mittels eines komplexen Pulsformungsfilters 2 in ein komplexes Basisbandsignal $x(k) = i(k) + jq(k)$ gewandelt. Mit einer digitalen Rechenschaltung 3 wird das komplexe Basisbandsignal x(k) in kartesischer Darstellung in ein entsprechendes Signal $x(k) = r(k) \cdot e^{j\varphi(k)}$ in Polar-Darstellung transformiert. Dabei beschreiben die Größe r(k) ein Betragssignal und die Größe φ(k) ein Phasensignal.

Mittels eines auf einer PLL (phase-locked loop), insbesondere einer direkt modulierten PLL, basierenden Aufwärtswandlers 4 wird aus dem digitalen Phasensignal φ(k) ein in Abhängigkeit des Phasensignals φ(k) moduliertes analoges Trägersignal $y(t) \sim \cos(\omega_c \cdot t + \Phi(t))$ generiert. Dabei entspricht die Größe $\omega_c$ der Trägerkreisfrequenz. Die Phase Φ(t) ist von dem Phasensignal φ(k) und der Modulationsart (beispielsweise Phasenmodulation oder Frequenzmodulation) abhängig. Das digitale Betragssignal r(k) wird durch einen Digital/Analog-Wandler 5 in ein analoges Signal gewandelt, welches anschließend mit einem Rausch-Filter 6 zur Verringerung des Quantisierungsräuschens gefiltert wird, wobei ein analoges Betragssignal r(t) erzeugt wird. Das analoge Trägersignal y(t) und das analoge Betragssignal r(t) werden mittels eines Multiplizierers 7 multipliziert. Der Multiplizierer 7 führt also eine Amplitudenmodulation des analogen Trägersignals y(t) in Abhängigkeit des analogen Betragssignals r(t) durch. Das resultierende Signal $s(t) = r(t) \cdot y(t)$ wird vor der Abstrahlung über die Antenne mit einem Leistungsverstärker (nicht dargestellt) verstärkt.

In Fig. 2 ist eine Ausführungsform eines Polar-Modulators dargestellt. Mit gleichen Bezugszeichen versehene Schaltungsteile und Signale in Fig. 1 und Fig. 2 entsprechen einander. Im Unterschied zu dem in Fig. 1 dargestellten Polar-Modulator erfolgt die Amplitudenmodulation hier erst in der Ausgangsstufe des Leistungsverstärkers 8. Dazu wird die Leistungsverstärkung des Leistungsverstärkers 8 in Abhängigkeit des analogen Betragssignals r(t) über einen Modulationseingang 10 moduliert. Zur Modulation der Leistungsverstärkung wird typischerweise die Versorgungsspannung der Ausgangsstufe des Leistungsverstärkers 8 moduliert. Alternativ können auch die die Verstärkung bestimmenden Ruheströme der Ausgangsstufe des Leistungsverstärkers moduliert werden. Die Modulation der Versorgungsspannung erfolgt über einen in Fig. 2 nicht dargestellten LDO-Spannungsregler (Low Dropout Regulator). Ein zusätzlicher Multiplizierer 7 wie in Fig. 1 ist bei dem in Fig. 2 dargestellten Polar-Modulator nicht notwendig.

Ein wesentlicher Vorteil des in Fig. 2 dargestellten Polar-Modulators gegenüber dem in Fig. 1 dargestellten Polar-Modulator ist, dass keine Linearität zwischen dem Eingangssignal y'(t) (y'(t) wird durch einen begrenzenden Verstärker 9 aus dem Signal y(t) generiert) und dem Ausgangssignal des Leistungsverstärkers 8 erforderlich ist. Die Amplitudeninformation r(k) der zu übertragenden Symbole x(k) findet ohnehin erst in der Ausgangsstufe Berücksichtigung. Aufgrund der reduzierten Linearitätsanforderungen an den Leistungsverstärker 8 arbeitet ein derartiger Polar-Modulator besonders leistungseffizient. Der Ansatz, erst in der Ausgangsstufe des Leistungsverstärkers 8 die Amplitudenmodulation vorzunehmen, wird auch als EER-Verfahren (envelope elimination and restoration) bezeichnet und geht auf die Veröffentlichung "Single-Sideband Transmission by Envelope Elimination and Restoration", L. Kahn, Proceedings of I.R.E., Juli 1952, Seiten 803 - 806, zurück. Nachteilig an dem in Fig. 2 dargestellten Polar-Modulator ist die Verzerrung des Ausgangssignals s(t) durch den Leistungsverstärker 8. So verursachen der Leistungsverstärker 8, insbesondere die dem Modulationseingang 10 nachfolgenden analogen Schaltungskomponenten, sowie die den Modulationseingang 10 ansteuernden analogen Schaltungsteile eine Betragsverzerrung, welche auch als AM-AM-Verzerrung (AM - Amplituden-Modulation) bezeichnet wird, d. h. der Zusammenhang zwischen der Amplitude des Ausgangssignals s(t) und dem Betragssignal r(k) ist nicht-linear. Ferner bewirkt der Leistungsverstärker 8 eine Phasenverzerrung, welche auch als AM-PM-Verzerrung (PM - Phasen-Modulation) bezeichnet wird, d. h. eine zusätzliche Phasenverschiebung in Abhängigkeit der Amplitude des Betragssignals r(k).

Aus der Druckschrift "Polar Modulator for Multimode Cell Phones", W. Sander et al., Proc. IEEE Custom Integrated Circuits Conf., Sept. 2003, Seiten 439 - 445, ist es bekannt, das digitale Betragssignal r(k) und das digitale Phasensignal φ(k) jeweils einer Vorverzerrung zu unterziehen, so dass die AM-AM-Verzerrung und die AM-PM-Verzerrung kompensiert werden. In Fig. 3 ist ein um eine Vorverzerrung erweiterter Polar-Modulator dargestellt, welcher auf dem in Fig. 2 dargestellten Polar-Modulator basiert. Mit gleichen Bezugszeichen versehene Schaltungsteile und Signale in Fig. 2 und Fig. 3 entsprechen einander. Der Polar-Modulator umfasst einen digitalen Betragsvorverzerrer 11 und einen digitalen Phasenvorverzerrer 12, welche die durch den Leistungsverstärker 8 hervorgerufene AM-AM-Verzerrung bzw. AM-PM-Verzerrung kompensieren.

In der Druckschrift US 6,366,177 B1 ist ein Ansatz zur Einstellung der Vorzerrung beschrieben. Dazu sind am Ausgang des Leistungsverstärkers spezielle Mess-Schaltungen vorgesehen, welche den Betrag bzw. die Phasenmodulation des verzerrten Hochfrequenzsignals s(t) bei jeweils fester Phasenmodulation ermitteln. Die gemessene Betrags- und die Phaseninformation wird dazu verwendet, die Vorzerrung so einzustellen, dass die Verzerrung durch den Leistungsverstärker im Wesentlichen kompensiert wird. Nachteilig an diesem Ansatz ist, dass die Realisierung der Mess-Schaltungen einen hohen Schaltungsaufwand erfordert. Insbesondere wird zur Ermittlung der Phasenmodulation zunächst eine Abwärtswandlung des Hochfrequenzsignals s(t) in ein Basisbandsignal erforderlich sein.

Die Druckschrift US 2004/0151257 A1 beschreibt einen Transceiver mit einem Polarmodulator in der Sendeeinrichtung. Daabei sind einem ersten und einem nachgeschalteten zweiten Leistungsverstärker einstellbare Betrags- und ein Phasenvorverzerrer vorgeschaltet. Zur Einstellung der Vorverzerrer wird der Ausgang der Sendeeinrichtung mit dem Eingang der Empfangseinrichtung gekoppelt. Die Druckschrift US 2003/0035499 A1 beschreibt eine beispielhafte Empfangseinrichtung für einen solchen Transceiver.

Es ist Aufgabe der Erfindung, eine Sende-/und Empfangseinrichtung mit einem Polar-Modulator bereitzustellen, dessen Vorverzerrung mit einem im Vergleich zu herkömmlichen Ansätzen geringeren Schaltungsaufwand eingestellt werden kann. Ferner ist die Erfindung darauf gerichtet, ein entsprechendes Verfahren zur Einstellung einer Vorverzerrung in einem Polar-Modulator einer Sende-/Empfangseinrichtung anzugeben.

Die der Erfindung zugrunde liegenden Aufgabenstellungen werden durch die Merkmale der unabhängigen Ansprüche 1 UND 12 gelöst.

Die erfindungsgemäße Sende-/Empfangseinrichtung für ein Mobilfunkgerät umfasst einen auf dem EER-Verfahren basierenden Polar-Modulator, d. h. der Modulator weist einen modulierbaren Verstärker auf. Ferner ist zumindest ein in Signalrichtung dem Verstärker vorgeschalteter Vorverzerrer vorgesehen, wobei der Vorverzerrer einstellbar ist. Der Vorverzerrer basiert beispielsweise auf einer Lookup-Tabelle. Außerdem umfasst die Sende-/Empfangseinrichtung einen Empfangspfad, welcher wahlweise entweder zum Empfang von Funksignalen oder im Rahmen der Einstellung des zumindest einen Vorverzerrers verwendet werden kann. In letzterem Fall liefert der Empfangspfad ein von dem Ausgangssignal des Verstärkers abhängiges Mess-Signal. Darüber hinaus ist in der Sende-/Empfangseinrichtung zur Einstellung des zumindest einen Vorverzerrers ein Koppelpfad vorgesehen, welcher den Eingang des Empfangspfads mit dem Ausgang des Verstärkers elektrisch verkoppelt. Die Sende-/Empfangseinrichtung weist ferner ein Steuer- und Auswertemittel auf, welches der Einstellung des zumindest einen Vorverzerrers in Abhängigkeit des Mess-Signals dient.

Der Polar-Modulator und der Empfangspfad weisen einen Aufwärtswandler in Form einer direkt modulierten PLL oder in Form eines Mischers mit einem Lokal-Oszillator-Generator, bzw. einen Abwärtswandler auf. Der Aufwärtswandler dient dabei der Umsetzung des digitalen Phasensignals oder eines davon abhängigen Signals in ein moduliertes Hochfrequenzsignal.

Gemäß einem ersten Aspekt der Erfindung wird der LO-Eingang (LO: Lokal-Oszillator) des Abwärtswandlers in Abhängigkeit eines von dem Aufwärtswandler generierten Hochfrequenzsignals, insbesondere in Abhängigkeit des modulierten Hochfrequenzsignals oder eines von dem modulierten Hochfrequenzsignal abhängigen Signals, angesteuert.

Durch diese Maßnahme wird bewirkt, dass der Polar-Modulator und der Empfangspfad frequenzsynchron zueinander arbeiten. Eine Bestimmung der Trägerfrequenz $f_c$ des eingekoppelten Signals ist in diesem Fall in dem Empfangspfad nicht notwendig. Handelt es sich bei dem Empfangspfad um einen homodynen Empfangspfad, bei dem die Empfangssignale ohne Verwendung einer Zwischenfrequenz in das Basisband gemischt werden, kann durch Mischung mit einem die Trägerfrequenz $f_c$ aufweisenden LO-Signal die Mittenfrequenz des eingekoppelten Signals direkt auf 0 Hz abwärtsgewandelt werden. Für den Fall, dass der Aufwärtswandler als direkt modulierte PLL realisiert ist, liefert die PLL kein monofrequentes Hochfrequenzsignal mit der Trägerfrequenz $f_c$, sondern lediglich ein moduliertes Hochfrequenzsignal mit der Mittenfrequenz $f_c$. Zur Verhinderung einer Selbstmischung kann optional das modulierte Hochfrequenzsignal vor der Einspeisung in den LO-Eingang des Abwärtswandlers schmalbandig gefiltert werden, so dass die Modulation unterdrückt wird.

In diesem Zusammenhang sei angemerkt, dass der Abwärtswandler zur Erzeugung der I- und Q-Signalanteile typischerweise zwei einzelne Mischer umfasst, welche über zwei zueinander orthogonale LO-Signale angesteuert werden, d. h. über den LO-Eingang des Abwärtswandlers werden zwei Hochfrequenzsignale eingespeist (oder das zweite orthogonale Signal wird intern im Abwärtswandler generiert). Wird in dem Aufwärtsmischer ein Frequenzteiler mit einem Teilungsverhältnis von 2 verwendet, liefert dieser ohne zusätzlichen Schaltungsaufwand zwei orthogonale Hochfrequenzsignale (Abgriff nach dem ersten Latch und nach dem zweiten Latch des Frequenzteilers).

Gemäß einem zweiten Aspekt der Erfindung wird der Aufwärtswandler über ein Referenz-Signal mit einer Referenz-Frequenz synchronisiert, beispielsweise bei einer direkt modulierten PLL mit einem Frequenzteiler. Die Referenz-Frequenz ist dabei im Allgemeinen deutlich geringer als die Trägerfrequenz $f_c$; beispielsweise liegt die Referenz-Frequenz bei 26 MHz, während die Trägerfrequenz bei 910 MHz liegt (Teilungsverhältnis 35:1). Die Sende-/Empfangseinrichtung umfasst einen Oberwellen-Generator zur Generierung einer oder mehrerer Oberwellen der Referenz-Frequenz. Der Lokal-Oszillator-Eingang des Abwärtswandlers wird in Abhängigkeit einer oder mehrerer der von dem Oberwellen-Generator erzeugten Oberwellen angesteuert. Typischerweise handelt es sich bei dem Oberwellen-Generator um einen Rechteck-Generator, welcher ein Rechteck-Signal erzeugt, dessen Grundfrequenz der Referenz-Frequenz entspricht. In diesem Fall weist das Ausgangssignal einen sogenannten Frequenz-Kamm mit einer Vielzahl von Oberwellen auf.

Dieser Ansatz bietet sich insbesondere dann an, wenn der Empfangspfad auf einem heterodynen Konzept, wie beispielsweise bei einem sogenannten Low-IF-Empfänger, basiert.

In diesem Zusammenhang ist darauf hinzuweisen, dass das Ausgangssignal des Oberwellen-Generators auch als Referenz-Signal der PLL verwendet werden kann.

Wesentlicher Gedanke der erfindungsgemäßen Sende-/Empfangseinrichtung ist die Doppelnutzung des Empfangspfads. Der Empfangspfad als Teil des Empfängers wird einerseits für den Empfang von Funksignalen verwendet, andererseits wird der Empfangspfad bei der Einstellung des zumindest einen Vorverzerrers genutzt. Im zweiten Fall wird das Ausgangssignal des Verstärkers über den Koppelpfad in den Empfangspfad eingekoppelt, wobei im Zuge einer Signalverarbeitung in dem Empfangspfad ein Mess-Signal generiert wird. Der Empfangspfad dient dabei typischerweise der Abwärtswandlung des eingekoppelten verzerrten Signals sowie optional einer anschließenden Analog/Digital-Wandlung, wobei beispielsweise als Mess-Signal Abtastwerte des I- und des Q-Anteils des Basisbandsignals ermittelt werden. Anhand des Mess-Signals lässt sich dann die Vorverzerrung, beispielsweise im Zuge eines Vergleiches des Mess-Signals mit dem unverzerrten Basisbandsignal, über das Steuer- und Auswertemittel so einstellen, dass die Verzerrung durch den Leistungsverstärker im Wesentlichen kompensiert wird.

Aufgrund der erfindungsgemäßen Doppelnutzung des Empfangspfades sind spezielle Mess-Schaltungen, wie sie im Stand der Technik zur Ermittlung des Betrags bzw. der Phasenmodulation des verzerrten Hochfrequenzsignals vorgesehen sind, nicht notwendig, so dass der Schaltungsaufwand deutlich reduziert wird.

An dieser Stelle sei darauf hingewiesen, dass nicht notwendigerweise sämtliche Blöcke des Empfangspfads bei der Einstellung der Vorverzerrung genutzt werden. Beispielsweise sind empfangsseitige Filter zur Kanalentzerrung bei der Einstellung der Vorverzerrung im Allgemeinen nicht notwendig, da in diesem Fall keine Signalübertragung über den Luftkanal stattfindet.

Vorteilhafterweise umfasst der Koppelpfad ein schaltbares Koppelmittel, beispielsweise in Form eines MOS-Transistors (MOS - metal oxide semiconductor) oder eines MOS-Transmission-Gates, welches bei der Einstellung des zumindest einen Vorverzerrers ein geringe Impedanz und beim gewöhnlichen Empfangsbetrieb eine hohe Impedanz aufweist. Es ist aber auch denkbar, dass der Koppelpfad sowohl im gewöhnlichen Empfangsbetrieb als auch bei der Einstellung des zumindest einen Vorverzerrers wirksam ist. Dies ist dann der Fall, wenn der Koppelpfad auf einer parasitären Koppelung basiert. Beispielsweise weist ein Duplexer eine parasitäre Koppelung zwischen dem Transmitter-Anschluss und dem Receiver-Anschluss auf.

Vorteilhafterweise umfasst der Polar-Modulator zur Kompensation beider Verzerrungsarten, nämlich der AM-AM-Verzerrung und der AM-PM-Verzerrung, einen einstellbaren Betragsvorverzerrer und einen einstellbaren Phasenvorverzerrer.

Vorteilhafterweise umfasst das Steuer- und Auswertemittel ein Vergleichsmittel, welches einen Vergleich des Mess-Signals (beispielsweise Abtastwerte des I- und Q-Anteils des Basisbandsignals) oder eines davon abhängigen Signals mit dem sendeseitigen komplexen Basisbandsignal oder einem mit dem sendeseitigen komplexen Basisbandsignal zusammenhängenden Signal durchführt. Der Vergleich beider Signale kann auf der Basis von kartesischen Koordinaten oder alternativ auf der Basis von polaren Koordinaten durchgeführt werden. Außerdem kann sich der Vergleich auch nur auf die Betragsinformation beziehen.

Der Begriff "Vergleich" umfasst im Sinne der Anmeldung auch das Auswerten einer Fehlerfunktion zweier Vergleichssignale, beispielsweise in der Form $|x - \overline{x}|^2$ (x: komplexes Basisbandsignal, x: komplexes Mess-Signal; alternativ: x: Betrag oder Phase des komplexen Basisbandsignals, x: gemessener Betrag oder gemessene Phase).

Vorteilhafterweise ist das Mess-Signal ein komplexes digitales Signal in kartesischer Darstellung. In diesem Fall ist es von Vorteil, wenn das Steuer- und Auswertemittel ein Transformations-Mittel zum Transformieren des Mess-Signals oder eines davon abhängigen Signals in ein komplexes Signal in Polar-Koordinaten-Darstellung umfasst. In diesem Fall wird der Vergleich auf der Basis von polaren Koordinaten der Vergleichssignale durchgeführt, d. h. das transformierte Signal wird dann typischerweise mit dem dem Ausgangssignal des Verstärkers zugrunde liegenden komplexen Basisbandsignal verglichen.

Außerdem ist es im Sinne der Anmeldung denkbar, dass das Transformations-Mittel lediglich den Betrag oder das Betragsquadrat des komplexen Mess-Signals ermittelt, wobei der Vergleich dann lediglich auf Betragsinformationen und nicht auf Phaseninformationen beruht.

Statt eines Vergleichsmittels kann in dem Steuer- und Auswertemittel vorteilhafterweise ein Signalverarbeitungs-Mittel vorgesehen werden, welches in Abhängigkeit des Mess-Signals ein für die durch den Verstärker hervorgerufene spektrale Aufweitung charakteristisches Signal bereitstellt. Diese vorteilhafte Ausführungsform der Sende-/Empfangseinrichtung basiert auf dem Gedanken, dass die Nichtlinearität des Verstärkers zu einer Aufweitung des Sendespektrums führt. Dieser Effekt wird im angelsächsischen Sprachgebrauch auch als "spectral regrowth" bezeichnet.

Anhand des durch das Signalverarbeitungs-Mittel generierten Signals lässt sich der Grad der Verzerrung des Ausgangssignals des Verstärkers feststellen. Diese Information kann dazu genutzt werden, den zumindest einen Vorverzerrer derart einzustellen, dass die Verzerrung des Ausgangssignals des Verstärkers minimiert wird.

In diesem Fall ist es von Vorteil, wenn das Mess-Signal im Wesentlichen lediglich Spektralanteile eines oder mehrerer außerhalb des eigentlichen Sendekanals liegender Frequenzbereiche umfasst. Dies kann bei einem Homodyn-Empfänger beispielsweise mittels eines zusätzlichen Mischers realisiert werden, dessen LO-Frequenz der Frequenzablage relativ zur Mittenfrequenz des Sendekanals entspricht. Außerdem umfasst das Signalverarbeitungs-Mittel ein Mittel zum Bestimmen einer Größe, welche für die Leistung in dem bzw. in den außerhalb des Sendekanals liegenden Frequenzbereichen charakteristisch ist. Die so ermittelte Leistung außerhalb des eigentlichen Sendekanals ist ein Maß für die spektrale Aufweitung des Spektrums des Verstärker-Ausgangssignals und somit auch ein Maß für die Verzerrung des Verstärker-Ausgangssignals. Diese Information kann dazu genutzt werden, den zumindest einen Vorverzerrer derart einzustellen, dass die Verzerrung des Ausgangssignals des Verstärkers minimiert wird.

In diesem Zusammenhang sei darauf hingewiesen, dass die Frequenzbereiche beliebig schmal sein können und beispielweise nur eine bestimmte Frequenz umfassen. Außerdem wäre es denkbar, dass die Frequenzbereiche in den Randbereichen des Sendekanals liegen.

Die Einstellung der Vorverzerrung kann einmal während eines werkseitigen Tests und/oder regelmäßig beim Einschalten der Sende-/Empfangseinrichtung erfolgen. Vorteilhafterweise ist die Sende-/Empfangseinrichtung derart ausgestaltet, dass die Einstellung des zumindest einen Vorverzerrers im Betrieb der Sende-/Empfangseinrichtung mit einer bestimmten Periodizität erfolgt, insbesondere bei jedem k-ten Datenburst (k fest und k ≥ 1).

Die AM-AM-Verzerrung und die AM-PM-Verzerrung des Verstärkers sind typischerweise auch von äußeren Einflussgrößen wie Temperatur und Betriebsspannung abhängig. Erfolgt die Einstellung des Vorverzerrers im Betrieb der Sende-/Empfangseinrichtung mit einer bestimmten Periodizität kann die Vorverzerrung bei Schwankungen der äußeren Einflussgrößen, wie Temperaturschwankungen und Versorgungsspannungsschwankungen, nachgeführt werden. Temperaturschwankungen können beispielsweise durch einen monolithisch integrierten Temperatursensor gemessen werden. Bei einer Änderung der Temperatur kann die Einstellung der Vorverzerrung erneut durchgeführt werden. Ebenso kann ein Spannungsdetektor vorgesehen werden, der die Versorgungsspannung misst, wobei bei einer Änderung der Versorgungsspannung ebenfalls eine erneute Einstellung der Vorverzerrung initiiert wird.

Der zweite Aspekt der Erfindung ist auf ein Verfahren zur Einstellung einer Vorverzerrung in einem EER-basierten Polar-Modulator gerichtet. Dabei ist die Verzerrung des Verstärkers in dem Polar-Modulator mittels einer Vorverzerrung zumindest teilweise kompensierbar. Der Ausgang des Verstärkers ist mit dem Eingang eines Empfangspfads verkoppelt oder verkoppelbar. Der Empfangspfad wird sowohl im Rahmen der Einstellung der Vorverzerrung als auch im gewöhnlichen Empfangsbetrieb genutzt. In einem ersten Verfahrensschritt wird ein von dem Ausgangssignal des Verstärkers abhängiges Mess-Signal in dem Empfangspfad ermittelt. Das Mess-Signal wird ausgewertet und anhand des Auswerte-Ergebnisses wird die Vorverzerrung eingestellt.

Gemäß einer ersten alternativen Ausgestaltung des erfindungsgemäßen Verfahrens verarbeitet der Polar-Modulator im Rahmen der Einstellung der Vorverzerrung ein Kalibrationssignal, welches lediglich zur Einstellung der Vorverzerrung verwendet wird. Insbesondere wird bei der Einstellung der Vorverzerrung ein Kalibrationssignal mit treppenförmigem Betragsverlauf verwendet.

Falls zur Einstellung der Vorverzerrung ein Kalibrationssignal verwendet wird, sollte zur Vermeidung von Störungen des Mobilfunknetzes das im Allgemeinen nicht Standardkonforme Kalibrationssignal nur mit sehr geringer Leistung oder überhaupt nicht abgestrahlt werden. Ist in der Sende-/Empfangseinrichtung dem Verstärker ein zweiter Verstärker nachgeschaltet, ist es zweckmäßig, den zweiten Verstärker bei der Einstellung der Vorverzerrung zu deaktivieren.

Gemäß einer zweiten alternativen Ausgestaltung des erfindungsgemäßen Verfahrens erfolgt die Einstellung der Vorverzerrung im Rahmen des gewöhnlichen Sendebetriebs, d. h. der Polar-Modulator verarbeitet statt eines Kalibrationssignals ein im Rahmen des Sendebetriebs zu übertragendes Basisbandsignal.

Die vorstehenden Aussagen zu der erfindungsgemäßen Sende-/Empfangseinrichtung lassen sich in analoger Weise auf das erfindungsgemäße Verfahren zur Einstellung der Vorverzerrung übertragen.

Weitere vorteilhafte Ausgestaltungen der Erfindung sind in den Unteransprüchen angegeben.

Die Erfindung wird nachfolgend anhand mehrerer Ausführungsbeispiele unter Bezugnahme auf die Zeichnungen näher erläutert; in diesen zeigen:

Fig. 1 ein Prinzipschaltbild eines Polar-Modulators (Stand der Technik);

Fig. 2 ein Prinzipschaltbild eines nach dem EER-Verfahren arbeitenden Polar-Modulators (Stand der Technik);

Fig. 3 ein Prinzipschaltbild eines gegenüber Fig. 2 um eine Vorverzerrung erweiterten Polar-Modulators (Stand der Technik);

Fig. 4 ein Schaltbild eines ersten Ausführungsbeispiels einer erfindungsgemäßen Sende-/Empfangseinrichtung;

Fig. 5 ein Schaltbild eines zweiten Ausführungsbeispiels einer erfindungsgemäßen Sende-/Empfangseinrichtung für den GSM-900- und den GSM-1800-Betriebsmodus;

Fig. 6 ein Schaltbild eines dritten Ausführungsbeispiels einer erfindungsgemäßen Sende-/Empfangseinrichtung; und

Fig. 7 ein Schaltbild eines vierten Ausführungsbeispiels einer erfindungsgemäßen Sende-/Empfangseinrichtung.

Hinsichtlich der Fig. 1 bis 3 zum Stand der Technik wird auf die Beschreibungseinleitung verwiesen.

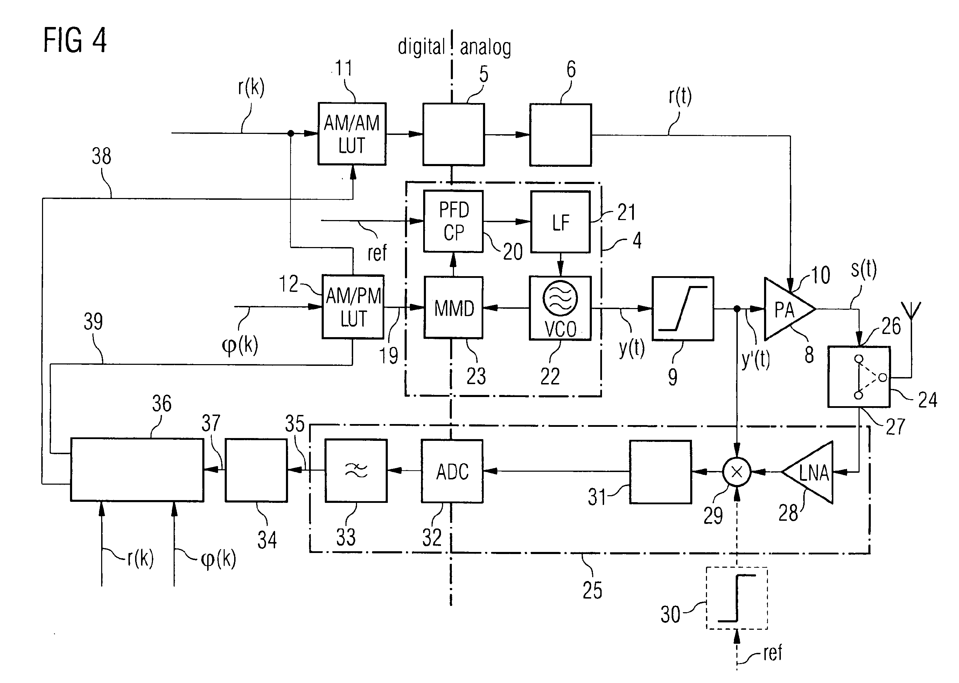

In Fig. 4 ist ein Schaltbild eines ersten Ausführungsbeispiels einer erfindungsgemäßen Sende-/Empfangseinrichtung dargestellt. Mit gleichen Bezugszeichen versehene Schaltungsblöcke und Signale in Fig. 3 und Fig. 4 entsprechen einander. Der in Fig. 4 sendeseitig verwendete Aufwärtswandler 4 basiert auf einer direkt modulierten PLL. Diese umfasst eine geschlossene Regel-Schleife, die einen Phasen-Frequenz-Detektor 20, ein Schleifen-Filter 21, einen spannungsgesteuerten Oszillator 22 (VCO - voltage controlled oscillator) und einen hinsichtlich des Teilungsverhältnisses einstellbaren Frequenzteiler 23 beinhaltet. Über einen Modulationseingang 19 wird die direkt modulierte PLL in der Frequenz ihres Ausgangssignals y(t) moduliert. Im stationären Betrieb der PLL gilt für die Frequenz $f_c$ des Signals y(t) am Ausgang der direkt modulierten PLL:

$$f_c = N \cdot f_{ref}$$

Dabei beschreibt $f_{ref}$ die Frequenz des Referenz-Signals ref der PLL und N das Teilungsverhältnis des Frequenzteilers 23.

Der in Fig. 4 dargestellte Betragsvorverzerrer 11 und der in Fig. 4 dargestellte Phasenvorverzerrer 12 können beispielsweise als Lookup-Tabellen (LUT) realisiert werden, wobei jeweils ein Tabellen-Wert die Vorverzerrung des Betrags- oder Phasenwerts in Abhängigkeit des jeweiligen Betragswerts bestimmt. Alternativ können die Vorverzerrer 11 und 12 als adaptive Filter, insbesondere als parametrische Filter, realisiert werden, wobei in diesem Fall die Filter-Koeffizienten die Vorverzerrung bestimmen.

Zur Einstellung der Vorverzerrer 11 und 12 wird das Ausgangssignal s (t) des Verstärkers 8 über einen Duplexer 24 in den Empfangspfad 25 der Sende-/Empfangseinrichtung eingekoppelt (Loopback-Betriebsmodus). Gewöhnlicherweise verbindet ein Duplexer 24 wahlweise entweder den Ausgang des Leistungsverstärkers oder den Eingang des Empfangspfads mit der Antenne. Bei der erfindungsgemäßen Sende-/Empfangseinrichtung kann vorgesehen sein, dass bei der Einstellung der Vorverzerrer 11 und 12 der Duplexer 24 den Ausgang des Leistungsverstärkers 8 mit dem Eingang des Empfangspfad selektiv verbindet, d. h. der Transmit-Eingang 26 und der Receive-Ausgang 27 des Duplexers 24 werden bei der Einstellung der Vorverzerrer 11 und 12 miteinander verbunden. Alternativ kann auch die parasitäre Koppelung zwischen dem Transmit-Eingang 26 und dem Receive-Ausgang 27 des Duplexers 24 zur Einkoppelung des Ausgangssignals s(t) des Leistungsverstärkers 8 in den Empfangspfad 25 ausgenutzt werden.

Das über den Duplexer 24 in den Empfangspfad eingekoppelte Signal wird zunächst mittels eines LNA 28 (low noise amplifier) verstärkt. Ist die Eingangsleistung aufgrund eines niederohmigen Koppelpfades über den Duplexer 24 sehr hoch, kann der LNA 28 auch überbrückt werden und das Ausgangssignal des ersten Verstärkers 8 direkt in den Eingang des Abwärtswandlers 29 gespeist werden (gestrichelte Verbindung). In diesem Fall wird insbesondere eine Übersteuerung des LNA 28 verhindert. Falls das Ausgangssignal des ersten Verstärkers 8 direkt in den Eingang des Abwärtswandlers 29 gespeist wird, sollte der LNA 28 während der Einstellung der Vorverzerrung ausgeschaltet sein, um eine möglichst hohe Isolation zur Antenne zu erzielen, da ansonsten bei einem vorhandenen Funk-Störsignal der Empfangspfad gestört werden könnte.

In diesem Zusammenhang muss beachtet werden, dass die Nichtlinearität des Empfangspfads 25 deutlich geringer als die Nichtlinearität des Polar-Modulators sein sollte. Dies kann insbesondere dadurch bewerkstelligt werden, dass die Verstärkung in dem Empfangspfad 25 optimal eingestellt wird, wobei dieser optimale Wert der Verstärkung a priori bekannt ist.

Das resultierende Signal wird einem Abwärtswandler zugeführt, welcher einen komplexen Mischer 29, d. h. zwei reelle Mischer, umfasst. Die zwei reellen Mischer werden zur Erzeugung des I- und des Q-Signalanteils von zwei orthogonalen LO-Signalen angesteuert. In Fig. 4 ist zur Vereinfachung der Darstellung lediglich ein LO-Signal dargestellt. Wird eine homodyne Empfänger-Architektur (Zero-IF-Receiver) verwendet, kann das LO-Signal aus dem von dem VCO 22 generierten modulierten Hochfrequenzsignal y(t) bzw. y'(t) abgeleitet werden. Zur Verhinderung einer Selbstmischung, bei der die Phaseninformation verloren ginge, sollte vor der Einspeisung in den LO-Eingang des Abwärtswandlers 29 mittels eines schmalbandigen Filters die Modulation aus dem modulierten Hochfrequenzsignals y(t) bzw. y'(t) entfernt werden (nicht dargestellt). Dies kann beispielsweise über eine schmalbandige PLL als Filter erfolgen, wobei das modulierte Hochfrequenzsignal y(t) bzw. y'(t) das Referenz-Signal der schmalbandigen PLL darstellt. Wird als Aufwärtswandler 4 ein komplexer Mischer verwendet, können die den komplexen Mischer ansteuernden unmodulierten orthogonalen LO-Signale ohne Filterung zur Ansteuerung des LO-Eingangs des Abwärtswandlers 29 verwendet werden.

Falls der Empfänger als heterodyner Empfänger mit einer niederfrequenten Zwischenfrequenz (Low-IF-Receiver) realisiert wird, kann alternativ das LO-Signal des ersten komplexen Mischers auch aus dem Referenz-Signal ref der PLL abgeleitet werden (gestrichelt dargestellt). Hierzu wird das Referenz-Signal ref einem Rechteck-Generator 30 zugeführt, welcher ein Rechteck-Signal erzeugt, dessen Grundfrequenz der Referenz-Frequenz $f_{ref}$ entspricht. Das Ausgangssignal des Rechteck-Generators 30 weist einen sogenannten Frequenz-Kamm mit einer Vielzahl von Oberwellen der Referenz-Frequenz $f_{ref}$ auf.

Das komplexe Ausgangssignal des Abwärtswandlers 29 wird zunächst mittels eines komplexen Polyphasen-Filters 31 gefiltert (typische Bandbreite für eine GSM-Applikation im Bereich von 200 kHz). Anschließend erfolgt eine Analog/DigitalWandlung mittels des Analog/Digital-Wandlers 32. Nachfolgend wird das digitale komplexe Ausgangssignal des Analog/DigitalWandlers 32 typischerweise mittels einer Mehrzahl von Filtern 33 (lediglich ein Filter in Fig. 4 dargestellt) weiterverarbeitet. Das Ausgangssignal 35 der Filterkette 33 bildet ein vom Empfangspfad 25 bereitgestelltes Mess-Signal, wobei das Mess-Signal 35 im Wesentlichen mit Hilfe der im gewöhnlichen Empfangsbetrieb verwendeten Schaltungsblöcke des Empfangspfads 25 generiert wird. Das komplexe Mess-Signal 35 in kartesischer Darstellung wird anschließend mittels eines Transformations-Mittels 34 in ein komplexes Signal 37 in Polar-Koordinaten-Darstellung gewandelt. Außerdem kann bei einem treppenförmigen Kalibrationssignal in dem Schaltungsblock 34 eine zeitliche Mittelwertbildung durchgeführt werden.

In dem Vergleichs-Mittel 36 wird zur Quantifizierung der Verzerrung das komplexe Signal 37 mit dem Betragssignal r(k) und dem Phasensignal φ(k) verglichen. Dies kann insbesondere in der Form erfolgen, dass bei der Einstellung der Vorverzerrer 11 und 12 in dem Vergleichs-Mittel 36 eine von den zu vergleichenden Signalen abhängige Fehlerfunktion minimiert wird. Beispielsweise kann die Fehlerfunktion $|x - \bar{x}|^2$ (x: skaliertes komplexes Basisbandsignal; x: skaliertes komplexes Mess-Signal 37 bzw. 35) minimiert werden. Zur Bestimmung der Tabellenwerte des AM-AM-Vorverzerrers 11 kann alternativ eine entsprechende Fehlerfunktion basierend auf dem sendeseitigen Betragssignal und der gemessenen Umhüllenden verwendet werden. Bei dem Vergleich müssen die Vergleichsgrößen entsprechend der in dem Sende- und Empfangspfad auftretenden Verstärkungs- und Dämpfungsfaktoren skaliert werden. Dies kann durch eine einmalige Skalierung des Empfangssignals erfolgen. Außerdem müssen die Vergleichsgrößen zeitrichtig zueinander verarbeitet werden.

Darüber hinaus kann der Vergleich in dem Vergleichs-Mittel 36 auch auf Basis von komplexen Vergleichsgrößen in kartesischer Darstellung erfolgen.

In Abhängigkeit des Werts der Fehlerfunktion werden zwei Steuersignale 38 und 39 generiert, wobei das Steuersignal 38 der Einstellung des Vorverzerrers 11 und das Steuersignal 39 der Einstellung des Vorverzerrers 12 dient.

Es kann vorgesehen sein, dass jeweils verschiedene Parametersätze für die Lookup-Tabellen abgespeichert sind, wobei über die Steuersignale 38 und 39 die Auswahl jeweils eines Parametersatzes erfolgt. Jeder der verschiedenen Parametersätze ist dabei einer anderen Nichtlinearitäts-Charakteristik des Leistungsverstärkers 8 zugeordnet.

Sind die Vorverzerrer 11 und 12 als digitale parametrische Filter realisiert, werden über die Steuersignale 38 und 39 die Filter-Koeffizienten geändert. Beispielsweise wird in Abhängigkeit der Steuersignale 38 und 39 jeweils ein Koeffizientensatz aus einer Mehrzahl von Koeffizientensätzen ausgewählt.

Im Zusammenhang mit Fig. 4 sei darauf hingewiesen, dass die Modulation der Ausgangsleistung des Verstärkers 8 über einen in Fig. 4 nicht dargestellten LDO-Spannungsregler erfolgt. Dies gilt in gleicher Weise für die nachfolgenden Ausführungsbeispiele.

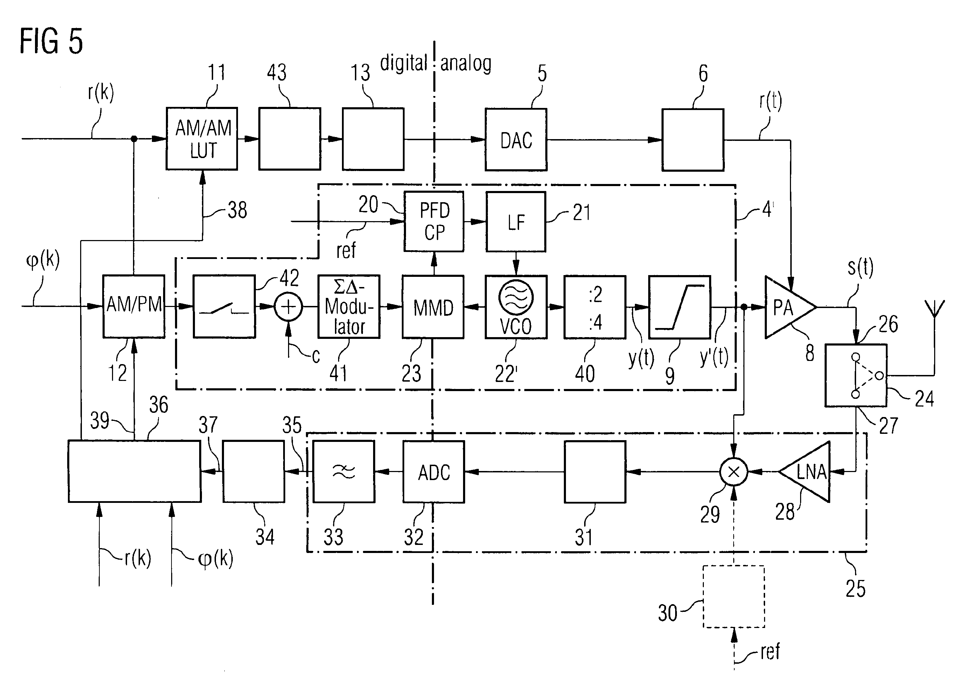

In Fig. 5 ist ein Schaltbild eines zweiten Ausführungsbeispiels einer erfindungsgemäßen Sende-/Empfangseinrichtung für den Einsatz in einem GSM-Mobiltelefon (GSM: Global System for Mobile Communications) dargestellt. Mit gleichen Bezugszeichen versehene Blöcke und Signale in Fig. 4 and Fig. 5 entsprechen einander. Bei diesem Ausführungsbeispiel handelt es sich um eine Sende-/Empfangseinrichtung, welche sowohl im GSM-900-Modus (d. h. im Frequenzbereich um 900 MHz) als auch im GSM-1800-Modus (d. h. im Frequenzbereich um 1800 MHz) betrieben werden kann.

Zur Erhöhung der Modulationsbandbreite der direkt modulierten PLL ist ein Kompensationsfilter 42 vorgesehen, wobei die Übertragungsfunktion des Kompensationsfilters 42 in etwa dem Inversen der Übertragungsfunktion der PLL vom Modulationseingang zum PLL-Ausgang entspricht. Das dem Kompensationsfilter 42 zugrunde liegende Konzept ist beispielsweise in der Dissertation "Techniques for High Data Rate Modulation and Low Power Operation of Fractional-N Frequency Synthesizers" von Michael Henderson Perrot, Massachussetts Institute of Technology, September 1997, genauer beschrieben. Dem Ausgangssignal des Kompensationsfilters 42 wird ein digitales Kanalwort c überlagert, welches die verwendete Trägerfrequenz $f_c$ festlegt. Der sich im Signalpfad anschließende Sigma-Delta-Modulator 41 erzeugt aus dem resultierenden digitalen Signal ein zeitlich schwankendes Signal, so dass das Teilungsverhältnis N des angesteuerten Frequenzteilers 23 der direkt modulierten PLL effektiv keine natürliche, sondern eine gebrochene Zahl darstellt. Daher wird eine wie in Fig. 5 dargestellte direkt modulierte PLL auch als Sigma-Delta-Fractional-N-PLL bezeichnet. Eine derartige Sigma-Delta-Fractional-N-PLL weist ein geringeres ausgangsseitiges Rauschen auf, da durch Verwendung des Sigma-Delta-Modulators 41 das Quantisierungsrauschen geringer ist. Der VCO 22' erzeugt dabei je nach GSM-Betriebsmodus ein Ausgangssignal mit der doppelten (GSM-1800-Modus) oder vierfachen (GSM-900-Modus) Frequenz des Sendesignals s(t). Im GSM-900-Modus weist der dem VCO 22' nachgeschaltete Frequenzteiler 40 ein Teilungsverhältnis von 4 auf, während im GSM-1800-Modus der Frequenzteiler 40 mit einem Teilungsverhältnis von 2 arbeitet.

In Bezug auf den Amplitudenmodulationspfad wird das Ausgangssignal des Betragsvorverzerrers 11 zunächst einer Einheit zur Offset-Korrektur 43 zugeführt. Das resultierende digitale Signal wird in einem Filter 13 einer Interpolation und einer Rausch-Filterung (noise shaping) unterzogen.

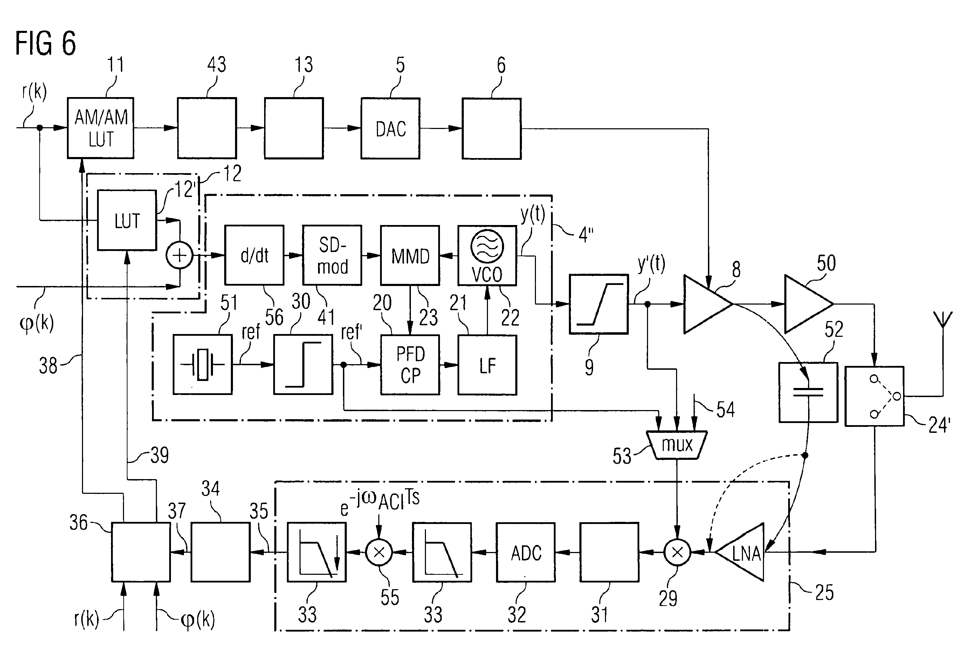

In Fig. 6 ist ein Schaltbild eines dritten Ausführungsbeispiels einer erfindungsgemäßen Sende-/Empfangseinrichtung dargestellt. Mit gleichen Bezugszeichen versehene Blöcke und Signale in Fig. 5 and Fig. 6 entsprechen einander.

Wesentliches Merkmal dieses Ausführungsbeispiels ist die Verwendung zweier Verstärker 8 und 50. Dabei erfolgt die Amplitudenmodulation lediglich über den ersten Verstärker 8. Der erste Verstärker 8 ist dabei zusammen mit den übrigen in Fig. 6 dargestellten Blöcken (ausgenommen davon sind der lediglich zwischen dem Sende- und dem Empfangsbetrieb umschaltbare Duplexer 24', der zweite Verstärker 50 und der QuarzOszillator 51) auf einem einzigen Chip in einer CMOS-Halbleiter-Technologie integriert. Der zweite Verstärker 50 hingegen ist in einer Bipolar- oder GaAs-FET-Halbleiter-Technologie implementiert. Obschon der Pegel am Eingang des zweiten Verstärkers 50 höher als am Eingang des ersten Verstärkers 8 ist, wird die Signalverzerrung im Allgemeinen hauptsächlich durch den ersten Verstärker 8 verursacht, da ein Verstärker in einer CMOS-Halbleiter-Technologie einen geringeren Linearitätsbereich als ein entsprechender Verstärker in einer Bipolar- oder GaAs-FET-Halbleiter-Technologie bei vergleichbarer Strukturauflösung aufweist.

Zur Einstellung der Vorverzerrer 11 und 12 ist es also häufig ausreichend, die Verzerrung des Ausgangssignals des ersten Verstärkers 8 statt der Verzerrung des Ausgangssignals des zweiten Verstärkers 50 zu messen. Dementsprechend wird das Ausgangssignal des ersten Verstärkers 8 über ein Koppelmittel 52 in den Eingang des Empfangspfades 25 eingekoppelt, insbesondere wird dazu eine Koppel-Kapazität verwendet. Die Einkoppelung kann schaltbar ausgeführt sein. Hierzu kann beispielsweise ein schaltbarer MOS-Transistor (MOS - metal oxide semiconductor) oder ein MOS-Transmission-Gate verwendet werden, welcher bzw. welches in Serie zu der Koppel-Kapazität angeordnet ist.

Das LO-Signal des Abwärtswandlers 29 kann über einen Multiplexer 53 ausgewählt werden. Das LO-Signal des Abwärtswandlers 29 wird wahlweise aus dem Rechtecksignal ref', dessen Grundfrequenz der Referenz-Frequenz $f_{ref}$ entspricht, oder aus dem modulierten Hochfrequenzsignal y'(t) abgeleitet. Alternativ kann auch ein externes LO-Signal 54 zur Ansteuerung des Abwärtswandlers 29 über den Multiplexer 53 ausgewählt werden. Das externe LO-Signal 54 kann beispielsweise bei einer werkseitigen Einstellung der Vorverzerrer 11 und 12 verwendet werden.

Falls zur Einstellung der Vorverzerrung ein nicht Standardkonformes Kalibrationssignal verwendet wird, sollte zur Vermeidung von Störungen des Mobilfunknetzes der zweite Verstärker 50 bei einer beim Nutzer durchgeführten (d. h. nicht werkseitigen) Einstellung der Vorverzerrung deaktiviert werden.

Der in Fig. 6 dargestellte digitale Frequenzwandler 55 wird bei der wie vorstehend beschriebenen Analyse des Mess-Signals 35 nicht verwendet, d. h. dieser stellt in diesem Fall einen Kurzschluss dar.

Alternativ zu der vorstehend beschriebenen Analyse des Mess-Signals in Form eines Signalvergleichs kann zur Einstellung der Vorverzerrer 11 und 12 die spektrale Aufweitung des Ausgangssignals des ersten Verstärkers 8 bestimmt werden. Die für diese alternative Signalauswertung notwendigen Blöcke sind bis auf den digitalen Frequenzwandler 55 in Fig. 6 nicht dargestellt. Dazu wird über die Wahl der Kreisfrequenz $\omega_{Acl}$ mittels des Frequenzwandlers 55 ein Nachbarkanal ausgewählt, beispielsweise ein zwei Kanäle neben dem Sendekanal liegender Kanal. Die Frequenz $f_{Acl} = \omega_{Acl}/2\pi$ (beispielsweise $f_{Acl} \approx 400$ kHz) entspricht bei einer homodynen Empfängerstruktur der Frequenzablage von der Trägerfrequenz $f_c$. Das Mess-Signal 35 umfasst in diesem Fall lediglich die Spektralanteile des ausgewählten Nachbarkanals. Außerhalb dieses Bands liegende Spektralanteile werden durch das dem Frequenzwandler 55 nachfolgende Filter 33 unterdrückt. Mit einem Signalverarbeitungs-Mittel (nicht dargestellt) werden die Leistung des Mess-Signals 35 und damit die Leistung in dem ausgewählten Nachbarkanal ermittelt. Die Steuersignale 38 und 39 werden so gewählt, dass die ermittelte Leistung des ausgewählten Nachbarkanals und damit auch die spektrale Aufweitung möglichst gering sind. Bei der Bestimmung der spektralen Aufweitung mittels der Messung einer Nachbarkanal-Leistung ist es notwendig, die absolute Leistung des Ausgangsignals des ersten Verstärkers 8 zu berücksichtigen.

Statt einer Leistungsmessung eines gesamten Nachbarkanals kann auch die spektrale Leistungsdichte bei einer einzelnen Frequenz (oder bei diskreten Frequenzpunkten) ermittelt werden, beispielsweise bei einer Frequenzablage von 400 kHz.

Insbesondere die Messung der spektralen Aufweitung kann während des gewöhnlichen Betriebs des Mobilfunkgeräts mit einem Standard-konformen Basisbandsignal x(k) durchgeführt werden. In diesem Fall ist der zweite Verstärker 50 aktiviert.

Fig. 6 zeigt außerdem ein Realisierungsbeispiel für den Phasenvorverzerrer 12. Dieses Realisierungsbeispiel kann in entsprechender Weise auch auf die Ausführungsbeispiele in den Fig. 4 und 5 übertragen werden. In Abhängigkeit des Betragssignals r(k) werden Phasenkorrekturwerte aus einer Lookup-Tabelle 12' ausgewählt, die mit dem Phasensignal $\varphi(k)$ additiv überlagert werden.

Der sich an den Phasenvorverzerrer 12 anschließende Differenzierer 56 als Teil des Aufwärtswandlers 4" dient dazu, die Phaseninformation in eine Frequenzinformation zu wandeln, da die direkt modulierte PLL über den Frequenzteiler 23 in ihrer Frequenz moduliert wird. In den Fig. 4 und 5 wurde auf die Darstellung des Differenzierers 56 aus Gründen der Vereinfachung verzichtet.

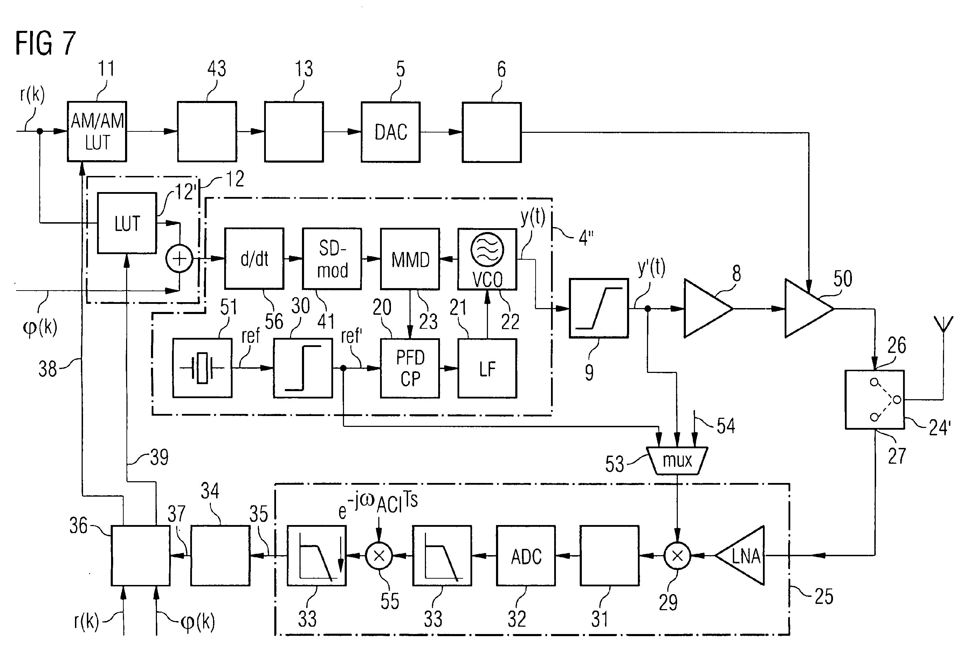

In Fig. 7 ist ein Schaltbild eines vierten Ausführungsbeispiels einer erfindungsgemäßen Sende-/Empfangseinrichtung dargestellt. Mit gleichen Bezugszeichen versehene Blöcke und Signale in Fig. 6 and Fig. 7 entsprechen einander. Der wesentliche Unterschied zwischen dem Ausführungsbeispiel in Fig. 6 und dem Ausführungsbeispiel in Fig. 7 ist, dass in Fig. 7 das Ausgangssignal des zweiten Verstärkers 50 zur Einstellung der Vorverzerrer 11 und 12 in den Empfangspfad eingekoppelt wird. Zur Signaleinkoppelung dient der parasitäre Koppelpfad zwischen dem Transmit-Eingang 26 und dem Receive-Ausgang 27 des Duplexers 24'.

## Patentansprüche

1. Sende-/Empfangseinrichtung für ein Mobilfunkgerät, mit

 - einem auf der Verarbeitung eines digitalen komplexen Basisbandsignals (x(k)) in Form eines digitalen Betragssignals (r(k)) und eines digitalen Phasensignals ($\varphi(k)$) basierenden Polar-Modulator, welcher

 -- einen ersten Verstärker (8) zur Verstärkung eines von dem digitalen Phasensignal ($\varphi(k)$) abhängigen Hochfrequenzsignals (y'(t)), dessen Ausgangsleistung in Abhängigkeit des digitalen Betragssignals (r(k)) modulierbar ist, und
 -- zumindest einen in Signalrichtung dem ersten Verstärker (8) vorgeschalteten Vorverzerrer (11, 12) zur zumindest teilweisen Kompensation einer durch den ersten Verstärker (8) hervorgerufenen Verzerrung mit einstellbarer Vorverzerrung

 umfasst,
 - einen zweiten Verstärker (50), der dem ersten Verstärker (8) nachgeschaltet ist,
 - einem Empfangspfad (25), welcher sowohl

 -- zum Empfang von Funksignalen als auch
 -- im Rahmen der Einstellung des zumindest einen Vorverzerrers (11, 12) zur Ermittlung eines von dem Ausgangssignal (s(t)) des ersten Verstärkers (8) abhängigen Mess-Signals (35)

 dient,
 - einem Koppelpfad zur elektrischen Verkoppelung des Eingangs des Empfangspfads (25) mit dem Ausgang des ersten Verstärkers (8), wobei der zweite Verstärker (50) im Rahmen der Einstellung des zumindest einen Vorverzerrers (11, 12) deaktiviert wird, und
 - einem Steuer- und Auswertemittel (34, 36) zur Einstellung des zumindest einen Vorverzerrers (11, 12) in Abhängigkeit des Mess-Signals (35).

2. Sende-/Empfangseinrichtung nach Anspruch 1, wobei der Koppelpfad ein schaltbares Koppelmittel umfasst.

3. Sende-/Empfangseinrichtung nach einem der Ansprüche 1 oder 2, wobei der Polar-Modulator zwei Vorverzerrer (11, 12) umfasst, nämlich

 - einen Betragsvorverzerrer (11) mit einstellbarer Betragsvorverzerrung zur zumindest teilweisen Kompensation einer durch den Verstärker (8) hervorgerufenen Betragsverzerrung und
 - einen Phasenvorverzerrer (12) mit einstellbarer Phasenvorverzerrung zur zumindest teilweisen Kompensation einer durch den ersten Verstärker (8) hervorgerufenen Phasenverzerrung.

4. Sende-/Empfangseinrichtung nach einem der Ansprüche 1 bis 3, wobei

- der Polar-Modulator einen Aufwärtswandler (4, 4', 4''), in Form einer direkt modulierten PLL, zur Umsetzung des digitalen Phasensignals ($\varphi(k)$) oder eines davon abhängigen Signals in ein moduliertes Hochfrequenzsignal (y(t)) umfasst, und

- der Empfangspfad einen Abwärtswandler (29) umfasst, dessen Lokal-Oszillator-Eingang in Abhängigkeit des modulierten Hochfrequenzsignals oder eines von dem modulierten Hochfrequenzsignal abhängigen Signals, angesteuert wird.

5. Sende-/Empfangseinrichtung nach einem der Ansprüche 1 bis 3, wobei

- der Polar-Modulator einen Aufwärtswandler (4, 4', 4'') in Form einer direkt modulierten PLL, zur Umsetzung des digitalen Phasensignals ($\varphi(k)$) oder eines davon abhängigen Signals in ein moduliertes Hochfrequenzsignal umfasst, welcher über ein Referenz-Signal (ref) mit einer Referenz-Frequenz synchronisiert wird,

- dass die Sende-/Empfangseinrichtung einen Oberwellen-Generator (30) zur Generierung einer oder mehrerer Oberwellen der Referenz-Frequenz umfasst, und

- dass der Empfangspfad einen Abwärtswandler (29) umfasst, dessen Lokal-Oszillator-Eingang in Abhängigkeit einer oder mehrerer der von dem Oberwellen-Generator (30) erzeugten Oberwellen angesteuert wird.

6. Sende-/Empfangseinrichtung nach einem der vorhergehenden Ansprüche, wobei das Steuer- und Auswertemittel (34, 36) ein Mittel zum Vergleichen (36)

- des Mess-Signals (35) oder eines davon abhängigen Signals (37) mit

- dem komplexen Basisbandsignal (r(k), $\varphi(k)$) oder einem mit dem komplexen Basisbandsignal zusammenhängenden Signal

umfasst.

7. Sende-/Empfangseinrichtung nach Anspruch 6, wobei

- das Mess-Signal (35) ein komplexes digitales Signal in kartesischer Darstellung ist, und

- das Steuer- und Auswertemittel (34, 36) ein Transformations-Mittel (34) zum Transformieren des Mess-Signals (35) oder eines davon abhängigen Signals in ein komplexes Signal (37) in Polar-Koordinaten-Darstellung umfasst.

8. Sende-/Empfangseinrichtung nach einem der Ansprüche 1 bis 5, wobei das Steuer- und Auswertemittel (34, 36) ein Signalverarbeitungs-Mittel umfasst, welches in Abhängigkeit des Mess-Signals ein für die durch den Verstärker hervorgerufene spektrale Aufweitung charakteristisches Signal bereitstellt.

9. Sende-/Empfangseinrichtung nach Anspruch 8, wobei

- das Mess-Signal (35) im Wesentlichen Spektralanteile eines oder mehrerer außerhalb des Sendekanals liegender Frequenzbereiche umfasst, und

- das Signalverarbeitungs-Mittel ein Mittel zum Bestimmen einer für die Leistung in dem bzw. in den außerhalb des Sendekanals liegenden Frequenzbereichen charakteristischen Größe umfasst.

10. Sende-/Empfangseinrichtung nach einem der vorhergehenden Ansprüche, wobei die Sende-/Empfangseinrichtung derart ausgestaltet ist, dass die Einstellung des zumindest einen Vorverzerrers (11, 12) bei jedem k-ten gesendeten Datenburst erfolgt, mit k $\geq$ 1.

11. Sende-/Empfangseinrichtung nach einem der vorhergehenden Ansprüche, wobei der zumindest eine Vorverzerrer (11, 12) auf einer Look-up-Tabelle basiert.

12. Verfahren zur Einstellung einer Vorverzerrung in einem Polar-Modulator einer Sende-/Empfangseinrichtung eines Mobilfunkgeräts, wobei

- der Polar-Modulator auf der Verarbeitung eines digitalen komplexen Basisbandsignals (x(k)) in Form eines digitalen Betragssignals (r(k)) und eines digitalen Phasensignals ($\varphi(k)$) basiert,

- eine Verzerrung durch einen im Polar-Modulator befindlichen ersten Verstärker (8) hervorgerufen wird, welcher ein von dem digitalen Phasensignal ($\varphi(k)$) abhängiges Hochfrequenzsignal (y'(t)) verstärkt und dessen Ausgangsleistung in Abhängigkeit des digitalen Betragssignals (r(k)) modulierbar ist,

- die Verzerrung mittels einer der Verzerrung vorhergehenden, einstellbaren Vorverzerrung (11, 12) zumindest teilweise kompensierbar ist, und

- der Ausgang des ersten Verstärkers (8) mit dem Eingang eines Empfangspfads (25) verkoppelt oder verkoppelbar ist, wobei der Empfangspfad (25) sowohl im Rahmen der Einstellung der Vorverzerrung als auch zum Empfang von Funksignalen genutzt wird, wobei im Rahmen der Einstellung der Vorverzerrung ein zweiter Verstärker (50), welcher dem ersten Verstärker (8) nachgeschaltet ist, deaktiviert wird;

mit den Schritten:

a) Ermitteln eines von dem Ausgangssignal (s(t)) des Verstärkers abhängigen Mess-Signals (35) in dem Empfangspfad (25) ;
b) Auswerten des Mess-Signals (35); und
c) Einstellen der Vorverzerrung (11, 12) entsprechend dem Auswerte-Ergebnis im Verfahrensschritt b).

13. Verfahren nach Anspruch 12, mit dem vor Verfahrensschritt a) durchzuführenden Schritt:

- Verkoppeln des Ausgangs des ersten Verstärkers (8) mit dem Eingang des Empfangspfads (25).

14. Verfahren nach einem der Ansprüche 12 oder 13, wobei die Vorverzerrung (11, 12)

- eine einstellbare Betragsvorverzerrung (11) zur zumindest teilweisen Kompensation einer durch den ersten Verstärker (8) hervorgerufenen Betragsverzerrung und
- eine einstellbare Phasenvorverzerrung (12) zur zumindest teilweisen Kompensation einer durch den ersten Verstärker (8) hervorgerufenen Phasenverzerrung

beinhaltet.

15. Verfahren nach einem der Ansprüche 12 bis 14, wobei im Verfahrensschritt b) folgender Schritt durchgeführt wird:

- Vergleichen

-- des Mess-Signals (35) oder eines davon abhängigen Signals (37) mit
-- dem komplexen Basisbandsignal (r(k), φ(k)) oder einem mit dem komplexen Basisbandsignal zusammenhängenden Signal.

16. Verfahren nach Anspruch 15 wobei

- das Mess-Signal (35) ein digitales komplexes Signal in kartesischer Darstellung ist, und
- im Verfahrensschritt b) folgender Schritt durchgeführt wird:

-- Transformieren des Mess-Signals (35) oder eines davon abhängigen Signals in ein komplexes Signal (37) in Polar-Koordinaten-Darstellung.

17. Verfahren nach einem der Ansprüche 12 bis 14 wobei im Verfahrensschritt b) folgender Schritt durchgeführt wird:

b1) Ermitteln eines für die durch den Verstärker hervorgerufene spektrale Aufweitung charakteristischen Signals in Abhängigkeit des Mess-Signals (35).

18. Verfahren nach Anspruch 17, wobei im Verfahrensschritt b1) folgende Schritte durchgeführt werden:

- Auswählen eines zu dem Sendekanal benachbarten Kanals, so dass das Mess-Signal (35) im Wesentlichen Spektralanteile eines außerhalb des Sendekanals liegenden Frequenzbereiches umfasst; und
- Bestimmen einer für die Leistung in dem außerhalb des Sendekanals liegenden Frequenzbereichs charakteristischen Größe.

19. Verfahren nach einem der Ansprüche 12 bis 18, wobei die Einstellung der Vorverzerrung (11, 12) bei jedem k-ten gesendeten Datenburst erfolgt, mit k ≥ 1.

20. Verfahren nach einem der Ansprüche 12 bis 19, wobei im Rahmen der Einstellung der Vorverzerrung (11, 12) der Polar-Modulator ein lediglich im Rahmen der Einstellung der Vorverzerrung verwendetes Kalibrationssignal (r(k), φ(k)) verarbeitet.

21. Verfahren nach einem der Ansprüche 12 bis 19, wobei im Rahmen der Einstellung der Vorverzerrung der Polar-Modulator ein im Rahmen des Sendebetriebs zu übertragendes Basisbandsignal (r(k), φ(k)) verarbeitet.

22. Verfahren nach Anspruch 20, wobei das Kalibrationssignal (r(k), φ(k)) einen treppenförmigen Betragsverlauf aufweist.

**Claims**

1. Transmission/reception device for a mobile radio, having

- a polar modulator that is based on the processing of a digital complex baseband signal (x(k)) in the form of a digital magnitude signal (r(k)) and a digital phase signal (φ(k)) and that comprises

-- a first amplifier (8) for amplifying a radiofrequency signal (y'(t)) that is dependent on the digital phase signal ($\varphi$(k)) and the output power of which can be modulated on the basis of the digital magnitude signal (r(k)), and

-- at least one predistorter (11, 12), connected upstream of the first amplifier (8) in the signal direction, for at least partially compensating for distortion brought about by the first amplifier (8) using adjustable predistortion,

- a second amplifier (50) that is connected downstream of the first amplifier (8),
- a reception path (25) that is used both

-- for receiving radio signals and
-- for adjusting the at least one predistorter (11, 12) to ascertain a measurement signal (35) that is dependent on the output signal (s(t)) from the first amplifier (8),

- a coupling path for electrically coupling the input of the reception path (25) to the output of the first amplifier (8), wherein the second amplifier (50) is deactivated for adjusting the at least one predistorter (11, 12), and
- a control and evaluation means (34, 36) for adjusting the at least one predistorter (11, 12) on the basis of the measurement signal (35).

2. Transmission/reception device according to Claim 1, wherein the coupling path comprises a switchable coupling means.

3. Transmission/reception device according to either of Claims 1 and 2, wherein the polar modulator comprises two predistorters (11, 12), specifically

- a magnitude predistorter (11) with adjustable magnitude predistortion for at least partially compensating for magnitude distortion brought about by the amplifier (8), and
- a phase predistorter (12) with adjustable phase predistortion for at least partially compensating for phase distortion brought about by the first amplifier (8).

4. Transmission/reception device according to one of Claims 1 to 3,

- wherein the polar modulator comprises an up-converter (4, 4', 4''), in the form of a directly modulated PLL, for converting the digital phase signal ($\varphi$(k)) or a signal that is dependent thereon into a modulated radio-frequency signal (y(t)), and
- the reception path comprises a down-converter (29), the local oscillator input of which is actuated on the basis of the modulated radio-frequency signal or a signal that is dependent on the modulated radio-frequency signal.

5. Transmission/reception device according to one of Claims 1 to 3,

- wherein the polar modulator comprises an up-converter (4, 4', 4'') in the form of a directly modulated PLL, for converting the digital phase signal ($\varphi$(k)) or a signal that is dependent thereon into a modulated radio-frequency signal that is synchronized to a reference frequency using a reference signal (ref),
- the transmission/reception device comprises a harmonic generator (30) for generating one or more harmonics of the reference frequency, and
- the reception path comprises a down-converter (29), the local oscillator input of which is actuated on the basis of one or more of the harmonics produced by the harmonic generator (30).

6. Transmission/reception device according to one of the preceding claims, wherein the control and evaluation means (34, 36) comprises a means for comparing (36)

- the measurement signal (35) or a signal (37) that is dependent thereon with
- the complex baseband signal (r(k), $\varphi$(k)) or a signal related to the complex baseband signal.

7. Transmission/reception device according to Claim 6,

- wherein the measurement signal (35) is a complex digital signal in Cartesian representation, and
- the control and evaluation means (34, 36) comprises a transformation means (34) for transforming the measurement signal (35) or a signal that is dependent thereon into a complex signal (37) in polar coordinate representation.

8. Transmission/reception device according to one of Claims 1 to 5, wherein the control and evaluation means (34, 36) comprises a signal processing means that takes the measurement signal as a basis for providing a signal that is characteristic of the spectral widening brought about by the amplifier.

9. Transmission/reception device according to Claim 8,

- wherein the measurement signal (35) essentially comprises spectral components of one or more frequency ranges outside the transmission channel, and

- the signal processing means comprises a means for determining a variable that is characteristic of the power in the frequency range(s) outside the transmission channel.

10. Transmission/reception device according to one of the preceding claims,
wherein the transmission/reception device is embodied such that the at least one predistorter (11, 12) is adjusted on every k-th data burst sent, where $k \geq 1$.

11. Transmission/reception device according to one of the preceding claims,
wherein the at least one predistorter (11, 12) is based on a look-up table.

12. Method for adjusting predistortion in a polar modulator of a transmission/reception device of a mobile radio, wherein

- the polar modulator is based on the processing of a digital complex baseband signal (x(k)) in the form of a digital magnitude signal (r(k)) and a digital phase signal ($\varphi$(k)),
- distortion is brought about by a first amplifier (8) in the polar modulator, which first amplifier amplifies a radio-frequency signal (y'(t)) that is dependent on the digital phase signal ($\varphi$(k)) and the output power of which can be modulated on the basis of the digital magnitude signal (r(k)),
- the distortion can be at least partially compensated for by means of adjustable predistortion (11, 12) that precedes the distortion, and
- the output of the first amplifier (8) is coupled or can be coupled to the input of a reception path (25), wherein the reception path (25) is used both for adjusting the predistortion and for receiving radio signals, the adjustment of the predistortion involving a second amplifier (50), which is connected downstream of the first amplifier (8), being deactivated;

having the steps of

a) ascertainment of a measurement signal (35), which is dependent on the output signal (s(t)) from the amplifier, in the reception path (25);
b) evaluation of the measurement signal (35); and
c) adjustment of the predistortion (11, 12) in line with the evaluation result in method step b).

13. Method according to Claim 12,
having the step, to be performed before method step a), of:

- coupling of the output of the first amplifier (8) to the input of the reception path (25).

14. Method according to either of Claims 12 and 13, wherein the predistortion (11, 12) contains

- adjustable magnitude predistortion (11) for at least partially compensating for magnitude distortion brought about by the first amplifier (8), and
- adjustable phase predistortion (12) for at least partially compensating for phase distortion brought about by the first amplifier (8).

15. Method according to one of Claims 12 to 14, wherein the following step is performed in method step b):

- comparison

-- of the measurement signal (35) or a signal (37) that is dependent thereon with
-- the complex baseband signal (r(k), $\varphi$(k)) or a signal related to the complex baseband signal.

16. Method according to Claim 15,

- wherein the measurement signal (35) is a digital complex signal in Cartesian representation, and
- the following step is performed in method step b):

-- transformation of the measurement signal (35) or a signal that is dependent thereon into a complex signal (37) in polar coordinate representation.

17. Method according to one of Claims 12 to 14, wherein the following step is performed in method step b):

b1) ascertainment of a signal that is characteristic of the spectral widening brought about by the amplifier on the basis of the measurement signal (35).

18. Method according to Claim 17,
wherein the following steps are performed in method step b1):

- selection of a channel that is adjacent to the transmission channel, so that the measurement signal (35) essentially comprises spectral components of a frequency range outside the transmission channel; and
- determination of a variable that is characteristic of the power in the frequency range outside the

13

**19.** Method according to one of Claims 12 to 18, wherein the predistortion (11, 12) is adjusted on every k-th data burst sent, where k ≥ 1.

**20.** Method according to one of Claims 12 to 19, wherein the adjustment of the predistortion (11, 12) involves the polar modulator processing a calibration signal (r(k), φ(k)) that is used just for adjusting the predistortion.

**21.** Method according to one of Claims 12 to 19, wherein the adjustment of the predistortion involves the polar modulator processing a baseband signal (r(k), φ(k)) that is to be transmitted for the transmission mode.

**22.** Method according to Claim 20, wherein the calibration signal (r(k), φ(k)) has a staircase-shaped magnitude profile.

**Revendications**

**1.** Dispositif d'émission/réception destiné à un terminal radio mobile, comportant

- un modulateur polaire basé sur le traitement d'un signal de bande de base numérique complexe (x(k)) sous la forme d'un signal d'amplitude numérique (r(k)) et d'un signal de phase numérique (φ(k)), qui comprend

- - un premier amplificateur (8) destiné à amplifier un signal à haute fréquence (y'(t)) dépendant du signal de phase numérique (φ(k)), dont la puissance de sortie est modulable en fonction du signal d'amplitude numérique (r(k)), et
- - au moins un dispositif de prédistorsion (11, 12) connecté en amont du premier amplificateur (8) dans la direction du signal, destiné à compenser au moins partiellement une distorsion provoquée par le premier amplificateur (8) par une prédistorsion réglable,

- un second amplificateur (50) qui est connecté en aval du premier amplificateur (8),
- un trajet de réception (25) qui est utilisé à la fois

- - pour la réception de signaux radio et
- - lors du réglage de l'au moins un dispositif de prédistorsion (11, 12) pour obtenir un signal de mesure (35) dépendant du signal de sortie (s(t)) du premier amplificateur (8),

- un trajet de couplage destiné à coupler électriquement l'entrée du trajet de réception (25) à la sortie du premier amplificateur (8), dans lequel le second amplificateur (50) est désactivé lors du réglage de l'au moins un dispositif de prédistorsion (11, 12), et
- un moyen de commande et d'évaluation (34, 36) destiné à régler l'au moins un dispositif de prédistorsion (11, 12) en fonction du signal de mesure (35).

**2.** Dispositif d'émission/réception selon la revendication 1, dans lequel
le trajet de couplage comprend un moyen de couplage connectable.

**3.** Dispositif d'émission/réception selon l'une quelconque des revendications 1 ou 2, dans lequel
le modulateur polaire comprend deux dispositifs de prédistorsion (11, 12), à savoir

- un dispositif de prédistorsion d'amplitude (11) ayant une prédistorsion d'amplitude réglable pour compenser au moins partiellement une distorsion d'amplitude provoquée par l'amplificateur (8), et
- un dispositif de prédistorsion de phase (12) ayant une prédistorsion de phase réglable pour compenser au moins partiellement une distorsion de phase provoquée par le premier amplificateur (8).

**4.** Dispositif d'émission/réception selon l'une quelconque des revendications 1 à 3, dans lequel le modulateur polaire comprend un convertisseur élévateur (4, 4', 4'') sous la forme d'une PLL à modulation directe, destiné à convertir le signal de phase numérique (φ(k)) ou un signal qui en dépend en un signal à haute fréquence modulé (y(t)), et

- le trajet de réception comprend un convertisseur élévateur (29) dont l'entrée d'oscillateur local est commandée en fonction du signal à haute fréquence modulé ou d'un signal dépendant du signal à haute fréquence modulé.

**5.** Dispositif d'émission/réception selon l'une quelconque des revendications 1 à 3, dans lequel

- le modulateur polaire comprend un convertisseur élévateur (4, 4', 4'') sous la forme d'une PLL à modulation directe, destiné à convertir le signal de phase numérique (φ(k)) ou un signal qui en dépend en un signal à haute fréquence modulé, qui est synchronisé sur un signal de référence (ref) ayant une fréquence de référence,
- le dispositif d'émission/réception comprend un générateur d'harmoniques (30) destiné à générer un ou plusieurs harmoniques de la fréquence de référence, et

- le trajet de réception comprend un convertisseur élévateur (29) dont l'entrée d'oscillateur local est commandée en fonction d'un ou plusieurs des harmoniques générés par le générateur d'harmoniques (30).

6. Dispositif d'émission/réception selon l'une quelconque des revendications précédentes, dans lequel le moyen de commande et d'évaluation (34, 36) comprend un moyen destiné à comparer (36)

    - le signal de mesure (35) ou un signal (37) qui en dépend
    - au signal de bande de base complexe (r(k), φ(k)) ou à un signal qui est associé au signal de bande de base complexe.

7. Dispositif d'émission/réception selon la revendication 6, dans lequel

    - le signal de mesure (35) est un signal numérique complexe dans une représentation cartésienne, et
    - le moyen de commande et d'évaluation (34, 36) est un moyen de transformation (34) destiné à transformer le signal de mesure (35) ou un signal qui en dépend en un signal complexe (37) dans une représentation en coordonnées polaires.

8. Dispositif d'émission/réception selon l'une quelconque des revendications 1 à 5, dans lequel le moyen de commande et d'évaluation (34, 36) comprend un moyen de traitement des signaux qui fournit, en fonction du signal de mesure, un signal caractéristique de l'élargissement spectral provoqué par l'amplificateur.

9. Dispositif d'émission/réception selon la revendication 8, dans lequel

    - le signal de mesure (35) comprend principalement des parties spectrales d'une ou plusieurs régions de fréquences se situant en dehors du canal d'émission, et
    - le moyen de traitement des signaux comprend un moyen destiné à déterminer une grandeur caractéristique de la puissance dans la ou les régions de fréquences se situant en dehors du canal d'émission.

10. Dispositif d'émission/réception selon l'une quelconque des revendications précédentes, dans lequel le dispositif d'émission/réception est configuré de manière à effectuer le réglage de l'au moins un dispositif de prédistorsion (11, 12) toutes les k salves de données émises, avec k ≥ 1.

11. Dispositif d'émission/réception selon l'une quelconque des revendications précédentes, dans lequel l'au moins un dispositif de prédistorsion (11, 12) est basé sur une table de consultation.

12. Procédé de réglage d'une prédistorsion dans un modulateur polaire d'un dispositif d'émission/réception d'un terminal radio mobile, dans lequel

    - le modulateur polaire est basé sur le traitement d'un signal de bande de base numérique complexe (x(k)) sous la forme d'un signal d'amplitude numérique (r(k)) et d'un signal de phase numérique (φ(k)),
    - une distorsion est provoquée par un premier amplificateur (8) se trouvant dans le modulateur polaire, qui amplifie un signal à haute fréquence (y'(t)) dépendant du signal de phase numérique (φ(k)) et dont la puissance de sortie est modulable en fonction du signal d'amplitude numérique (r(k)),
    - la distorsion peut être au moins partiellement compensée au moyen d'une prédistorsion (11, 12) réglable en amont de la distorsion, et
    - la sortie du premier amplificateur (8) est ou peut être couplée à l'entrée d'un trajet de réception (25), dans lequel le trajet de réception (25) est utilisé à la fois lors du réglage de la prédistorsion et pour la réception de signaux radio, dans lequel un second amplificateur (50) qui est connecté en aval du premier amplificateur (8) est désactivé lors du réglage de la prédistorsion;

    comprenant les étapes consistant à:

    a) obtenir un signal de mesure (35) dépendant du signal de sortie (s(t)) de l'amplificateur sur le trajet de réception (25);
    b) évaluer le signal de mesure (35); et
    c) régler la prédistorsion (11, 12) d'une manière qui correspond au résultat de l'évaluation de l'étape de procédé b).

13. Procédé selon la revendication 12, comprenant l'étape précédant l'étape de procédé a) consistant à:

    - coupler la sortie le premier amplificateur (8) à l'entrée du trajet de réception (25).

14. Procédé selon l'une quelconque des revendications 12 ou 13, dans lequel la prédistorsion (11, 12) comporte

    - une prédistorsion d'amplitude réglable (11) destinée à compenser au moins partiellement une distorsion d'amplitude provoquée par le premier amplificateur (8) et

- une prédistorsion de phase réglable (12) destinée à compenser au moins partiellement la distorsion de phase provoquée par le premier amplificateur (8).

15. Procédé selon l'une quelconque des revendications 12 à 14, dans lequel l'étape suivante est effectuée lors de l'étape de procédé b):

   - comparer

      - - le signal de mesure (35) ou un signal (37) qui en dépend
      - - au signal de bande de base complexe (r(k), φ(k)) ou à un signal associé au signal de bande de base complexe.

16. Procédé selon la revendication 15, dans lequel

   - le signal de mesure (35) est un signal complexe numérique dans une représentation cartésienne, et
   - l'étape suivante est effectuée lors de l'étape de procédé b) :

      - - transformer le signal de mesure (35) ou un signal qui en dépend en un signal complexe (37) dans une représentation en coordonnées polaires.

17. Procédé selon l'une quelconque des revendications 12 à 14, dans lequel lors de l'étape de procédé b), l'étape suivante est effectuée:

   b1) obtenir un signal caractéristique de l'élargissement spectral provoqué par l'amplificateur en fonction du signal de mesure (35).

18. Procédé selon la revendication 17, dans lequel lors de l'étape de procédé b1), les étapes suivantes sont effectuées:

   - sélectionner un canal voisin du canal d'émission de manière à ce que le signal de mesure (35) comprenne principalement des parties spectrales d'une région de fréquences se situant en dehors du canal d'émission; et
   - déterminer une grandeur caractéristique de la puissance dans la région de fréquences se situant en dehors du canal d'émission.

19. Procédé selon l'une quelconque des revendications 12 à 18, dans lequel le réglage de la prédistorsion (11, 12) s'effectue toutes les k salves de données émises, avec k ≥ 1.

20. Procédé selon l'une quelconque des revendications 12 à 19, dans lequel, lors du réglage de la prédistorsion (11, 12), le modulateur polaire traite un signal d'étalonnage (r(k), φ(k)) utilisé uniquement lors du réglage de la prédistorsion.

21. Procédé selon l'une quelconque des revendications 12 à 19, dans lequel, lors du réglage de la prédistorsion, le modulateur polaire traite un signal de bande de base (r(k), φ(k)) qui ne doit être transmis que lors du fonctionnement d'émission.

22. Procédé selon la revendication 20, dans lequel le signal d'étalonnage (r(k), φ(k)) présente une variation d'amplitude en escalier.

**FIG 1**

**FIG 2**

**FIG 3**

EP 1 691 518 B1

FIG 4

# FIG 5

r(k)

11 · AM/AM LUT — 43 — 13 — digital | analog — 5 · DAC — 6 — r(t)

38

φ(k)

12 · AM/PM — 42 — 41 · ΣΔ-Modu-lator — 23 · MMD — 22' · VCO — 40 · :2 :4 — 9 · y(t) y'(t) — 8 · PA — s(t)

c

20 · PFD CP — 21 · LF

ref

4'

39 · 36

37 · 34

35 · 33 · ≈ — 32 · ADC — 31 — 29 · ⊗ — 28 · LNA

r(k) · φ(k)

26 · 27 · 24

25

30 — ref

EP 1 691 518 B1

19

# FIG 6

EP 1 691 518 B1

# FIG 7

EP 1 691 518 B1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 6366177 B1
- US 20040151257 A1
- US 20030035499 A1

### In der Beschreibung aufgeführte Nicht-Patentliteratur

- **L. KAHN.** Single-Sideband Transmission by Envelope Elimination and Restoration. *Proceedings of I.R.E.,* Juli 1952, 803-806
- **W. SANDER et al.** Polar Modulator for Multi-mode Cell Phones. *Proc. IEEE Custom Integrated Circuits Conf.,* September 2003, 439-445
- **MICHAEL HENDERSON PERROT.** Techniques for High Data Rate Modulation and Low Power Operation of Fractional-N Frequency Synthesizers. Massachussetts Institute of Technology, September 1997